# EUROPÄISCHE PATENTANMELDUNG

(11) **EP 2 960 684 A1**
(43) Veröffentlichungstag der Anmeldung: **30.12.2015**
(21) Anmeldenummer: 14174557.0
(22) Anmeldetag: 26.06.2014
(51) Int. Cl.: G01V 3/08

(54) **Antennenanordnung**

(71) Anmelder: Ampass-Explorer Corp., Tortola (VG)
(72) Erfinder: Stauber, Siegfried, 8051 Zürich (CH)
(74) Vertreter: Klocke, Peter

(57) **Zusammenfassung**

Antennenanordnung auf einer Leiterplatte mit mindestens zwei Magnetringen und einem rechteckigen Ringquerschnitt und dadurch gebildeten seitlichen Magnetringflächen mit entgegengesetzter Polarität, die mittels eines Abstandshalters mit Abstand zueinander auf der Leiterplatte angeordnet sind, wobei die entgegengesetzten Polaritäten der Magnetringflächen einander zugewandt sind und die zentralen Löcher der Magnetringe über eine Bohrung im Abstandshalter eine Durchgangsbohrung bilden. Diese Antennenanordnung ist für eine Material-Detektoreinrichtung, mit der es möglich ist, Objekte eines vorgebbaren Materials über eine größere Distanz zu detektieren. Die Antennenanordnung ist durch ihren Aufbau beliebig in ihrer Wirkungsweise durch Vergrößerung der Anzahl der Magnetringe und der entsprechenden Abstandshalter erweiterbar. Durch ihr geringes Volumen kann sie leicht in bestehende Geräte integriert werden und ist kostengünstig herstellbar.

## Beschreibung

Die vorliegende Erfindung betrifft eine Antennenanordnung für eine Material-Detektoreinrichtung zum Orten von Objekten eines vorgebbaren Materials über eine größere Distanz durch Aussenden eines lonenstrahls und Empfangen eines zurückkommenden lonenstrahls, mit einer Leiterplatte mindestens zur Aufnahme von elektronischen Schaltkreisen und Bauelementen sowie einer Antenne und elektrischen Verbindungsleitungen zu der Antenne.

Aus der DE 10329335 ist eine Materialdetektoreinrichtung bekannt, die zum Orten von Objekten eines vorgebbaren Materials verwendet wird, indem ein elektromagnetisches Signal in Form eines lonenstrahls ausgesandt und das zurückkommende Signal detektiert wird. In dieser Schrift ist ebenfalls eine hierzu verwendete Sende- und Empfangsantenne beschrieben, die auf einer Leiterplatte angeordnet ist, welche mindestens zur Aufnahme von elektronischen Schaltkreisen und Bauelementen sowie elektronischen Verbindungsleitungen zu der Antenne dient. Eine Materialdetektoreinrichtung, mit der Materialien über eine Distanz von 1 bis 2 km detektiert werden können ist im Handel bei der Firma AMPASSMETER GmbH, Handwerkerhof 1, D-54338 Schweich erhältlich.

Der vorliegenden Erfindung liegt die Aufgabe zugrunde, eine neue Antennenanordnung vorzuschlagen, die im Aufbau wesentlich kleiner als die bekannte Antenne ist und dadurch auch einen Einbau in andere mobile Geräte erlaubt, um mit diesen Geräten zusätzlich die Ortung von Materialien zu ermöglichen.

Diese Aufgabe wird erfindungsgemäß durch eine Antennenanordnung mit den Merkmalen des Hauptanspruchs gelöst. Weitere vorteilhafte Ausgestaltungen sind den Unteransprüchen zu entnehmen.

Gemäß der Erfindung weist die Antennenanordnung mindestens zwei Magnetringe mit einem rechteckigen Ringquerschnitt auf, die mittels eines Abstandshalters mit Abstand zueinander auf der Leiterplatte angeordnet sind. Die rechteckigen Ringquerschnitte bilden seitliche Magnetringflächen mit entgegengesetzter Polarität, wobei die entgegengesetzten Polaritäten der Magnetringflächen einander zugewandt sind und die zentralen Löcher der Magnetringe über eine Bohrung im Abstandshalter eine Durchgangsbohrung bilden. Die Magnetringe können dabei beidseitig der Leiterplatte angeordnet sein, so dass die Leiterplatte als Abstandshalter dient und eine Bohrung aufweist, so dass eine Durchgangsbohrung durch die beiden Magnetringe und die Leiterplatte entsteht. Eine andere Möglichkeit besteht darin, die Magnetringe mit einem Abstandshalter mit Durchgangsbohrung auf einer Seite der Leiterplatte anzuordnen, so dass die von den Magnetringen und dem Abstandshalter gebildete Durchgangsbohrung entweder senkrecht oder im Wesentlichen parallel zu der Leiterplatte verläuft. Grundsätzlich können sich an jeden Magnetring weitere über Abstandshalter getrennte Magnetringe anschließen, wobei weiterhin die Magnetringe mit ihren Magnetringflächen mit entgegengesetzter Polarität einander zugewandt sind.

Die durch die Magnetringe und den Abstandshalter gebildete Antenne wird an eine elektronische Schaltung angeschlossen, so dass durch Anlegen einer Sägezahnspannung mit Pause um die Magnetringe und im Inneren der Magnetringe aus der Luft Sauerstoff- oder Stickstoff-Ionen erzeugt werden. Durch die Magnetringe und den dazwischen befindlichen Abstandshalter werden die Ionen beschleunigt aus der Durchgangsbohrung herausgeschleudert. Mehrere distanzierte Magnetringe ergeben eine höhere Geschwindigkeit der Kationen, bis eine Resonanzlawine entsprechend den Ionisationsenergiestufen entsteht. Dies bewirkt je nachdem in der Richtung Südpol - Nordpol einen Kationenstrahl für Sauerstoffund Stickstoff-Ionen und umgekehrt einen Anionenstrahl für Sauerstoff- und Stickstoff-Anionen. Allgemein gefasst: Eine Beschleunigungsstrecke für Sauerstoff- und Stickstoff-Ionen. Da die Kationen kleiner und leichter sind, werden diese stärker beschleunigt und weisen daher auch eine bessere Materialdurchgängigkeit auf, so dass sie wenig oder nicht mit Luftmolekülen zusammenstoßen. Die Kationen werden daher bevorzugt benutzt. Durch die Frequenz des Dreieckssignals und die Amplitude werden die entsprechenden Kationen auf das zu detektierende Material eingestellt. Tatsächlich werden überwiegend Sauerstoff-Kationen verwendet, da diese sich durch die geringeren Bindungskräfte schneller aus der Luft ionisiert werden. Treffen sie auf dem eingestellten Material entsprechende Kationen, so erfolgt eine Reflektion, die in den Sendepausen als elektrisches Signal in dem elektronischen Schaltkreis bei der Rückkehr zu den Magneten gemessen und ausgewertet werden kann. Die Anzeige erfolgt optisch und akustisch. Die Magnetringanordnung wirkt beim Beschleunigen der Kationen und Anionen ähnlich einer Ionenquelle. Durch die Verwendung eines Differenzverstärkers in der elektronischen Schaltung werden in bekannter Weise Störsignale unterdrückt.

Um den Durchgangsraum möglichst günstig für die Ausbildung und Beschleunigung von Ionen, insbesondere den Kationen, in diesem Bereich auszubilden, fluchtet gemäß einer bevorzugten Ausbildung der Erfindung die Bohrung im Abstandshalter mit den Bohrungen der Magnetringe.

Gemäß einer besonders bevorzugten Ausbildung der Erfindung ist der Abstandshalter für einen ersten und einen zweiten Magnetring die Leiterplatte, so dass auf platzsparende Art und Weise mindestens ein Magnetring auf jeder Seite der Leiterplatte, die eine entsprechende Durchgangsbohrung aufweist, angeordnet sind. Wie erwähnt, kann die Anordnung durch weitere Abstandshalter und Magnetringe erweitert werden.

Gemäß einer weiteren vorteilhaften Ausgestaltung ist auf der Leiterplatte eine Schaltung angeordnet, die über die Magnetringe ein Sägezahn- oder Dreieckssignal aussendet, dessen Zyklus auch eine Sendepause enthält, und das Rücksignal in einer Sendepause empfängt.

Die erfindungsgemäße Antennenanordnung erlaubt somit auf kleinstem Raum die Aussendung und den Empfang eines lonenstrahls und dessen Auswertung. Bei entsprechender Ausgestaltung des gesamten Gerätes mit der Antennenanordnung kann die Durchgangsbohrung gleichzeitig zum Peilen der Richtung des gesuchten Materials, beispielsweise mittels eines Laserpointerstrahls oder Laserdiodenstrahls, dienen. Für unzugängliche Orte, z.B. der Medizintechnik, kann auch ein Lichtwellenleiter (Durchmesser 1 mm) durch die Durchgangbohrung hindurchgesteckt werden, um Informationen vom anderen Ende des Lichtwellenleiters zu empfangen. Die Antennenanordnung kann aufgrund der Kleinheit auch in einem Mobiltelefon integriert werden, so dass damit dann ebenfalls eine Ortung von Materialen möglich ist,

Weitere Merkmale der Erfindung ergeben sich aus der folgenden Beschreibung der Ausführungsbeispiele in Verbindung mit den Ansprüchen, Beschreibung und den begleitenden Zeichnungen. Die einzelnen Merkmale können je für sich oder zu mehreren bei Ausführungsformen der Erfindung verwirklicht sein. Es stellen dar:
- Figur 1: eine schematische Schnittansicht einer Antennenanordnung, bei der eine Leiterplatte als Abstandshalter zwischen zwei Magnetringen dient;
- Figur 2: eine Antennenanordnung mit zwei Magnetringen und dazwischen liegendem Abstandshalter mit einer Durchgangsbohrung, im Wesentlichen parallel zur Leiterplatte; und
- Figur 3: die prinzipielle Darstellung eines Schaltkreises zur Ansteuerung der Antenne.

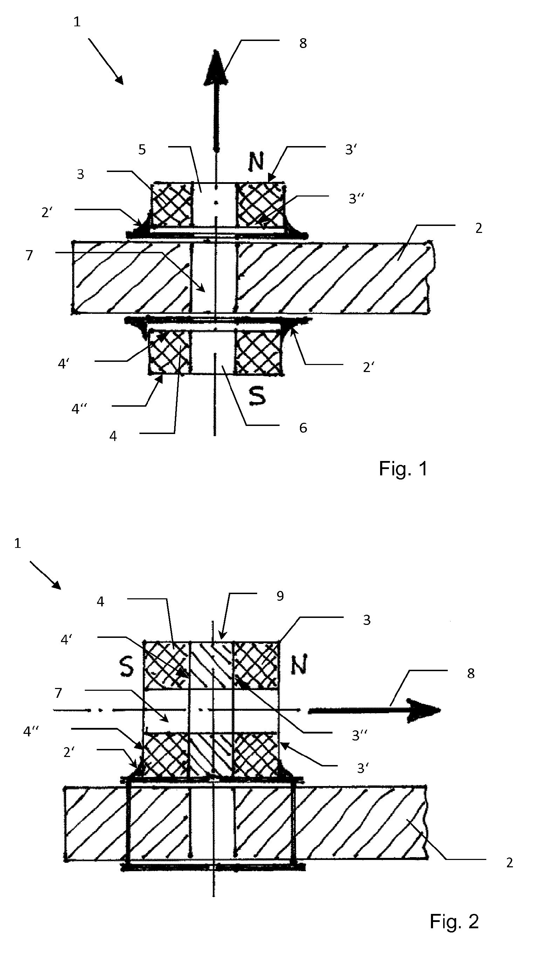

Figur 1 zeigt eine Antenne 1 mit einem Magnetring 3 und einem Magnetring 4, die auf beiden Seiten einer Leiterplatte 2 mittels Halterungen 2' angebracht sind. Die Magnetringe weisen einen rechteckförmigen, hier sogar quadratischen Querschnitt auf. Die seitlichen Magnetringflächen 3' und 4' wirken als Nordpol N und die die Magnetringflächen 3" und 4" als Südpol S. Die Löcher 5 und 6 der Magnetringe 3 bzw. 4 fluchten mit einer Bohrung 7 in der Leiterplatte 2 und bilden damit eine durchgängige Bohrung. Die Leiterplatte 2 dient als Abstandshalter zwischen den beiden Magnetringen 3, 4, die so angeordnet sind, dass die entgegengesetzten Pole einander zugewandt sind. Die beiden Magnetringe 3, 4 bilden jeweils eine Elektrode, die gesondert an eine in dieser Figur nicht dargestellte, auf der Leiterplatte 2 befindliche elektronische Schaltung angeschlossen sind. Der Pfeil 8 zeigt die Richtung an, in der die Sauerstoff- und Stickstoffkationen als Kationenstrahl aus dem durch die Löcher 5 und 6 und der Durchgangsbohrung 7 gebildeten Innenraum austreten. Ein Anionenstrahl wird sich gegebenenfalls in entgegengesetzter Richtung bewegen.

Figur 2 zeigt eine ähnliche Anordnung, bei der gleiche Teile mit gleichen Bezugszeichen versehen sind. Bei dieser Anordnung befinden sich beide Magnetringe 3 und 4 auf einer Seite der Leiterplatte 2. Zwischen den beiden Magnetringen 3 und 4 befindet sich ein Distanzstück 9 als Abstandhalter mit einer Durchgangsbohrung 7, welche mit den Löchern 5 bzw. 6 in den jeweiligen Magnetringen 3 bzw. 4 fluchtet. Hier befindet sich der Nordpol N auf der rechten Seite, so dass der Kationenstrahl aus Sauerstoff- und/oder Stickstoffkationen sich in Pfeilrichtung 8 bewegt.

Die in den Figuren 1 und 2 dargestellte Antenne mit zwei Magnetringen enthält in einem Ausführungsbeispiel als Magnetringmaterial Neodym. Die Magnetringe 3, 4 weisen eine Magnetstärke von 250 bis 300mT auf. Sowohl das Distanzstück 9 als auch die Leiterplatte 2 weisen eine Stärke von 1,5 bis 5 mm auf. Die Höhe eines Magnetringes 3, 4 kann 2 - 20 mm, der Außendurchmesser 6 - 50 mm und der Innendurchmesser 2 - 10 mm betragen. Die Antenne kann durch weitere Distanzstücke 9 und Magnetringe 3 erweitert werden.

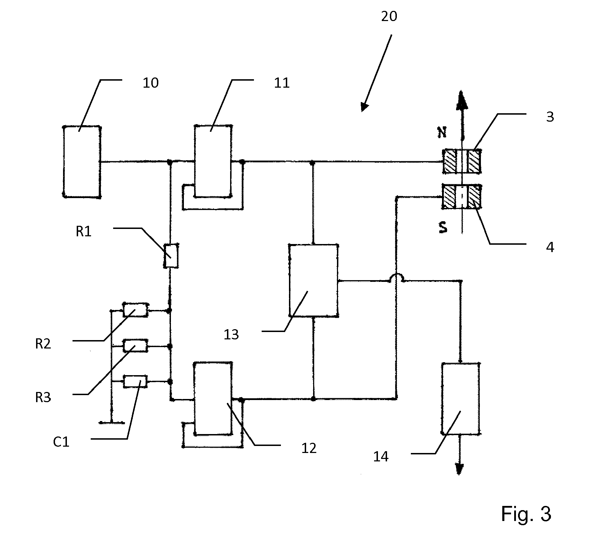

Figur 3 zeigt das Schema einer Antennenschaltung mit einem Dreiecksgenerator 10, an den parallel über Verstärker 11 und 12 die Magnetringe 3 bzw. 4 angeschlossen sind. Zwischen den Magnetringen 3, 4 ist ein Differenzverstärker 13 angeschlossen, der das erhaltene Signal über einen Analog-Digital-Wandler 14 an eine optische oder insbesondere akustische Anzeigeeinrichtung weiterleitet. Zwischen dem Verstärker 12 und dem Dreieckgenerator 10 befinden sich noch Widerstände zur Beschaltung. In dem Schema der Antennenschaltung ist ein Widerstand R1 in Reihe zu den Verstärkern 12 geschaltet, wobei zwischen Widerstand und dem Verstärker 12 parallele Widerstände R2 und R3 sowie der Kondensator C1 als übliche Spannungsteiler-Schaltung zur Änderung von Spannungen angeschlossen sind.

Der Dreieckgenerator erzeugt ein bekanntes Dreieck- oder Sägezahnsignal mit einer ansteigenden und einer abfallenden Flanke sowie einer Pause zwischen dem nächsten Dreiecksignal. An die beiden Magnetringe 3 und 4 wird in einem Ausführungsbeispiel eine Sägezahnspannung mit einer Amplitude von 70 mV mit einer Frequenz von 149,00 Hz der Sägezahnspannung angelegt, wobei die Pause 50 % einer Periode beträgt. Mit einer derartigen Frequenz kann reines Wasser detektiert werden. Durch die an den Magnetringen 3, 4 anliegende Spannung werden aus der die Magnetringe 3, 4 umgebenden und im Inneren befindlichen Luft Sauerstoff- und Stickstoff-Kationen und -Anionen herausgelöst. Diese werden aufgrund der oben beschriebenen Anordnung beschleunigt und aus der Anordnung herausbewegt. Wie vorstehend erwähnt, zeigt der Pfeil 8 die Richtung der Kationen an, die aufgrund ihrer geringeren Größe eine gute Materialdurchgängigkeit haben und darüber hinaus stärker beschleunigt werden als die in die entgegengesetzte Richtung bewegten Anionen. Treffen diese Kationen auf reines Wasser, wie in diesem Ausführungsbeispiel, so werden sie reflektiert. Andernfalls gehen sie durch das Material hindurch. Die zurückkommenden Kationen können dann in der Pause des Signals detektiert werden. Die Detektion erfolgt elektronisch, wobei für die Messung es äußerst vorteilhaft ist, mit einem Kopfhörer den Messvorgang zu verfolgen, um zu erkennen, in welche Richtung zurückkommende Signale auftreten. Die erfindungsgemäße Antennenanordnung wie vorstehend beschrieben ist beispielsweise in einer Materialdetektoreinrichtung eingebaut, die bei der Firma AMPASSMETER GmbH erhältlich ist und mit der derartige Messungen zur Auffindung von Materialien durchführbar sind. Die Detektion von verschiedenen Materialien erfolgt mit verschiedenen Frequenzen, die dem Benutzer eines derartigen Geräts zugänglich sind. Die Detektion der Materialien durch die Material-Detektoreinrichtung ist über eine Distanz von ein bis zwei Kilometern möglich.

## Patentansprüche

1. Antennenanordnung (1) für eine Material-Detektoreinrichtung zum Orten von Objekten eines vorgebbaren Materials über eine größere Distanz durch Aussenden eines lonenstrahls und Empfangen des zurückkommenden lonenstrahls, mit einer Leiterplatte mindestens zur Aufnahme von elektronischen Schaltkreisen und Bauelementen sowie einer Antenne und elektrischen Verbindungsleitungen zu der Antenne, **gekennzeichnet durch** mindestens zwei Magnetringe (3, 4) mit einem rechteckigen Ringquerschnitt und **dadurch** gebildeten seitlichen Magnetringflächen (3', 3"; 4', 4") mit entgegengesetzter Polarität, die mittels eines Abstandshalters (2, 9) mit Abstand zueinander auf der Leiterplatte (2) angeordnet sind, wobei die entgegengesetzten Polaritäten der Magnetringflächen (3', 3"; 4', 4") einander zugewandt sind und die zentralen Löcher (5, 6) der Magnetringe (3, 4) über eine Bohrung (7) im Abstandshalter (2, 9) eine Durchgangsbohrung bilden.

2. Antennenanordnung nach Anspruch 1, **dadurch gekennzeichnet, dass** die Bohrung (7) im Abstandshalter (2,9) mit den Löchern (5, 6) der Magnetringe (3, 4) fluchtet.

3. Antennenanordnung nach Anspruch 1 oder 2, **dadurch gekennzeichnet, dass** der Abstandshalter für einen ersten Magnetring (3) und einen zweiten Magnetring (4) die Leiterplatte (2) ist.

4. Antennenanordnung nach einem der vorangegangenen Ansprüche, **dadurch gekennzeichnet, dass** auf der Leiterplatte (3) eine Schaltung (20) angeordnet ist, die über die Magnetringe (3, 4) ein Signal aussendet und das Rücksignal in einer Sendepause empfängt.

## Geänderte Patentansprüche

### Geänderte Patentansprüche gemäss Regel 137(2) EPÜ.

1. Antennenanordnung (1) für eine Material-Detektoreinrichtung zum Orten von Objekten eines bestimmten Materials, das vorgebbar ist, über eine Distanz von bis zu zwei Kilometern durch Aussenden eines lonenstrahls und Empfangen des vom Objekt reflektierten zurückkommenden Ionenstrahls, wobei die Eigenschaften des zu detektierenden Materials die Reflektion des Ionenstrahls bewirken, mit einer Leiterplatte (2), mindestens zur Aufnahme von elektronischen Schaltkreisen und Bauelementen einer Antennenschaltung (20), sowie einer Antenne und elektrischen Verbindungsleitungen zu der Antenne, wobei die Antenne den Ionenstrahl aussendet und empfängt und die Antennenschaltung (20) das Sendesignal erzeugt und das Rücksignal auswertet, **dadurch gekennzeichnet, dass** die Antenne mindestens zwei Magnetringe (3, 4) mit einem rechteckigen Ringquerschnitt und dadurch gebildeten seitlichen Magnetringflächen (3', 3"; 4', 4") mit entgegengesetzter Polarität als Elektroden aufweist, die mittels mindestens eines mit einer Bohrung (7) ausgebildeten Abstandshalters (2, 9) mit Abstand zueinander auf der Leiterplatte (2) angeordnet sind, wobei die entgegengesetzten Polaritäten der Magnetringflächen (3', 3"; 4', 4") einander zugewandt sind und die zentralen Löcher (5, 6) der Magnetringe (3, 4) über die Bohrung (7) im Abstandshalter (2, 9) eine Durchgangsbohrung bilden, und dass die Magnetringe (3, 4) an der auf der Leiterplatte (2) angeordneten elektronische Antennenschaltung (20) angeschlossen sind, die an die Magnetringe (3, 4) ein sich wiederholendes Dreieck- oder Sägezahnsignal mit jeweils dazwischen liegender Pause zur Erzeugung des lonenstrahls anlegt, wobei die Amplitude und die Frequenz des Dreieck- oder Sägezahnsignal mit Pause über die Antennenschaltung (20) einstellbar ist und die Detektion von verschiedenen Materialien mit unterschiedlichen Frequenz und/oder Amplitude erfolgt.

2. Antennenanordnung nach Anspruch 1, **dadurch gekennzeichnet, dass** die Bohrung (7) im Abstandshalter (2, 9) mit den Löchern (5, 6) der Magnetringe (3, 4) fluchtet.

3. Antennenanordnung nach Anspruch 1 oder 2, **dadurch gekennzeichnet, dass** der Abstandshalter für einen ersten Magnetring (3) und einen zweiten Magnetring (4) die Leiterplatte (2) ist.

4. Antennenanordnung nach einem der vorangegangenen Ansprüche, **dadurch gekennzeichnet, dass** die Schaltung (20) über die Magnetringe (3, 4) ein Signal aussendet und das Rücksignal in einer Sendepause empfängt.
